(19) Europäisches Patentamt
European Patent Office
Office européen des brevets

(11) **EP 2 746 826 B1**

(12) **FASCICULE DE BREVET EUROPEEN**

(45) Date de publication et mention
de la délivrance du brevet:
**25.03.2020 Bulletin 2020/13**

(51) Int Cl.:
*G02B 5/20* *(2006.01)*      *G02B 5/18* *(2006.01)*
*H01L 31/0232* *(2014.01)*

(21) Numéro de dépôt: **13197770.4**

(22) Date de dépôt: **17.12.2013**

(54) **Filtre optique en fréquences et détecteur comportant un tel filtre.**

Optischer Frequenzfilter und Detektor, der mit einem solchen Filter ausgestattet ist

Optical frequency filter and detector comprising such a filter

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2012 FR 1262418**

(43) Date de publication de la demande:
**25.06.2014 Bulletin 2014/26**

(73) Titulaire: **COMMISSARIAT À L'ÉNERGIE ATOMIQUE ET AUX ÉNERGIES ALTERNATIVES 75015 Paris (FR)**

(72) Inventeur: **Espiau De Lamaestre, Roch 38000 GRENOBLE (FR)**

(74) Mandataire: **Gevers & Orès Immeuble le Palatin 2 3 Cours du Triangle CS 80165 92939 Paris La Défense Cedex (FR)**

(56) Documents cités:
**WO-A1-2012/105555     FR-A1- 2 959 021 US-A1- 2004 047 039     US-A1- 2009 041 971 US-A1- 2010 328 587**

• **Y. Kanamori ET AL: "Fabrication of Transmission Color Filters Using Silicon Subwavelength Gratings on Quartz Substrates", IEEE PHOTONICS TECHNOLOGY LETTERS., vol. 18, no. 20, 1 October 2006 (2006-10-01), pages 2126-2128, XP055549664, US ISSN: 1041-1135, DOI: 10.1109/LPT.2006.883208**

**Description**

La présente invention concerne les filtres optiques en fréquences utilisés notamment dans le domaine de la photodétection visible et infrarouge. Ils peuvent par exemple être utilisés pour la détection spectrale des gaz et pour l'imagerie couleur visible et infrarouge.

On connaît déjà des filtres optiques comprenant une couche de support, sur laquelle sont formés des éléments réflecteurs métalliques définissant un réseau de fentes plus petites que la longueur d'onde objet du filtrage. L'amplitude de la transmission est réglée à la fois par la largeur et l'épaisseur des fentes, l'épaisseur étant choisie de l'ordre de, mais inférieure à, la moitié de la longueur d'onde considérée.

Ce type de filtre a notamment été décrit dans les articles de J.A. Porto et al. « Transmission résonances on metallic gratings with very narrow slits », Physical Review Letters, 83, p.2845, 1999 et G. Vincent et al. « Large-area dielectric and metallic freestanding gratings for midinfrared optical filtering application », Journal of Vacuum Science Technology, B 26, p. 852, 2008.

Ainsi, ces types de filtre nécessitent des éléments réflecteurs épais qui sont parfois suspendus directement au-dessus de l'air, pour que l'indice de réfraction du support soit le plus proche possible de celui du milieu incident (air/vide).

Dans ces conditions, un tel filtre optique est difficile à réaliser technologiquement.

Par ailleurs, la plage spectrale pour laquelle une bonne réjection est assurée autour du pic principal de transmission est très limitée.

On connaît un autre filtre optique comprenant des éléments réflecteurs formant un réseau de fentes classique, une lame demi-onde supportant le réseau et un milieu au contact de la lame demi-onde et présentant avec elle un contraste d'indice de réfraction le plus important possible.

Un tel filtre optique est notamment décrit dans le document FR-2 959 021.

Avec un tel filtre, la lame demi-onde forme un guide d'onde sous le réseau de fentes, ce réseau étant par ailleurs capable d'exciter des modes plasmon de surface. La combinaison du réseau, de la lame et du fort contraste d'indice de réfraction permet de former un résonateur électromagnétique piégeant efficacement la lumière dans la lame avant que celle-ci ne s'échappe par le milieu au contact de la lame.

Par ailleurs, ce filtre optique est d'une fabrication simplifiée par rapport au filtre optique suspendu.

Cependant, ce filtre optique présente certains inconvénients.

En particulier, si ses dimensions peuvent être choisies de façon à optimiser la transmission à une longueur d'onde donnée, le spectre de transmission du filtre présente des pics significatifs en dehors de cette longueur d'onde.

Ceci entraîne donc une mauvaise réjection, au-delà d'une fenêtre assez étroite de longueur d'onde.

Ceci entraîne des limitations dans l'utilisation du filtre optique.

Ainsi, lorsque le filtre est utilisé pour l'imagerie hyperspectrale, la gamme spectrale d'intérêt est limitée. En effet, il peut se produire une interférence entre des pixels de couleurs différentes, ce qui complique la reconstruction des couleurs de l'image.

Par ailleurs, dans le cas d'une utilisation dans un capteur de gaz, il est important de discriminer spectralement de faibles signaux spécifiques d'espèces différentes. Or, les limitations du filtre optique conduisent à une détérioration du rapport signal/bruit de la détection.

US2009/0041971 décrit un film polarisant dont la fonction est de diviser un faisceau incident en deux faisceaux présentant des états de polarisation orthogonaux. A cet effet, il décrit une couche de réseau comprenant des portions constitués d'un matériau d'indice de réfraction différents et de hauteur égale de sorte que la face extérieure de la couche de réseau est plane.

US2010/0328587 décrit un filtre optique utilisant la résonance de modes guidée. Ce filtre comprend un substrat sur lequel est formé une structure périodique constituée d'une pluralité d'éléments en silicium agencés en deux dimensions selon une période comprise entre 400 nm et 500 nm. Les éléments en silicium ont une dimension dans une direction parallèle à la surface du substrat comprise entre 120 nm et 160 nm.

WO2012105555 décrit un filtre optique en polarisation et en longueur d'onde. Le filtre comprend un support en matériau diélectrique comprenant des inclusions en matériau non métallique et de hauteur strictement supérieure à celle du support.

L'invention a pour objet de pallier les inconvénients des filtres optiques de l'état de la technique en proposant un filtre optique en fréquences présentant une très bonne réjection sur une gamme spectrale très étendue, une bonne transmission sur une gamme spectrale étroite et une bonne insensibilité angulaire, tout en étant compact et d'une fabrication simplifiée.

Ainsi, l'invention concerne un filtre optique en fréquences comprenant une couche de support sur laquelle sont formés des éléments réflecteurs définissant au moins un réseau périodique de fentes sensiblement parallèles, la période P, la hauteur et la largeur des fentes étant choisies de façon à ce que les éléments réflecteurs forment une structure sélective en longueur d'onde pour une longueur d'onde comprise dans une gamme déterminée de longueurs d'onde.

Selon l'invention, la couche de support est formée d'un matériau d'indice de réfraction $n_h$ et comporte des inclusions en un matériau d'indice de réfraction $n_b$, $n_b$ étant strictement inférieur à $n_h$, ces inclusions affleurant sur la surface de la couche de support opposée à celle sur laquelle les éléments réflecteurs sont formés et présentant une hauteur $h_b$, telle que $0,5.h_h \leq h_b \leq 0,95.h_h$ où $h_h$ est la hauteur de la couche de support, et une largeur $l_b$, telle que $0,05P \leq l_b \leq 0,75P$, et chaque inclusion étant située au moins en partie entre deux éléments réflecteurs.

De préférence, la différence entre les deux indices de réfraction $n_h$ et $n_b$ est supérieure ou égale à $0,25\,n_h$.

De même, la hauteur $h_h$ de la couche de support sera telle que $0,85 \cdot \dfrac{\lambda}{2.n_h} \leq h_h \leq 1,5 \cdot \dfrac{\lambda}{2.n_h}$, où $\lambda$ est une longueur d'onde de la gamme prédéterminée de longueurs d'onde.

L'indice de réfraction $n_h$ sera de préférence supérieur ou égal à $5/3.n_{max}$, où $n_{max}$ est l'indice de réfraction le plus élevé des matériaux environnants.

De façon préférée, le filtre optique est disposé sur un substrat, une couche réalisée en un matériau d'indice de réfraction inférieur à $n_h$ étant disposée entre la couche de support et le substrat.

La largeur des fentes dudit au moins un réseau périodique est avantageusement inférieure au tiers de la période P du réseau.

Par ailleurs, les éléments réflecteurs sont avantageusement réalisés en un métal et ont une hauteur comprise entre l'épaisseur de peau du métal et $\dfrac{\lambda}{10.n}$, où n est l'indice de réfraction du matériau inclus dans les fentes et $\lambda$ est une longueur d'onde de la gamme prédéterminée de longueurs d'onde.

L'invention concerne également un détecteur pour la détection d'un rayonnement électromagnétique dans une gamme prédéterminée de longueurs d'onde, comprenant un circuit de détection sensible à ladite gamme de longueurs d'onde et un filtre optique selon l'invention.

L'invention sera mieux comprise et d'autres buts, avantages et caractéristiques de celle-ci apparaîtront plus clairement à la lecture de la description qui suit et qui est faite au regard des dessins annexés sur lesquels :

- la figure 1 est une vue en coupe d'un premier exemple de réalisation d'un filtre optique selon l'invention,
- les figures 2a à 2f représentent les différentes étapes d'un procédé d'obtention d'un deuxième exemple de réalisation d'un filtre optique selon l'invention,
- les figures 3 à 5 représentent chacune deux réponses en transmission, l'une pour un filtre optique selon l'invention et l'autre pour un filtre optique selon le deuxième mode de réalisation,
- la figure 6 représente deux réponses en transmission, l'une pour un filtre optique selon l'invention et l'autre pour un filtre similaire, dans laquelle une lame en semi-conducteur dopé est insérée,
- la figure 7 est une carte de la valeur maximale d'une fonction de coût F en fonction de la hauteur et de la largeur des inclusions dans un filtre optique selon l'invention, et

- la figure 8 est une carte de la longueur d'onde de résonnance en fonction de la hauteur et de la largeur des inclusions dans le filtre selon l'invention retenu pour la figure 7.

Les éléments communs aux différentes figures seront désignés par les mêmes références.

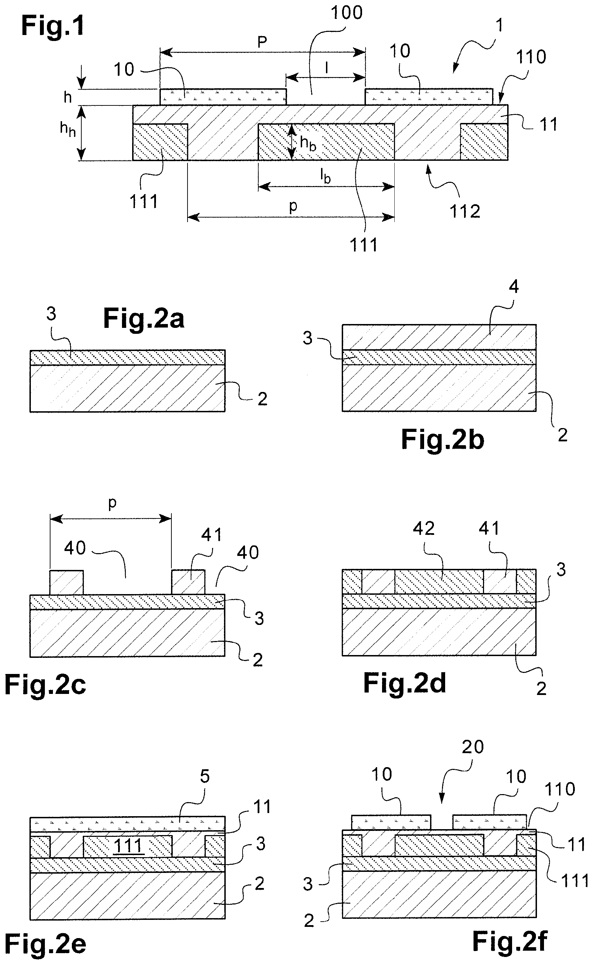

La figure 1 illustre un exemple d'un filtre optique 1 selon l'invention, vu en coupe.

Le filtre en fréquences 1 comporte des éléments réflecteurs 10 qui sont formés sur une face 110 d'une couche de support 11 en matériau diélectrique.

Les éléments réflecteurs 10 sont séparés par des fentes de largeur l. Ces fentes forment au moins un réseau de fentes sensiblement parallèles, ce réseau étant périodique, de période P.

Ainsi, le filtre 1 peut ne comporter qu'un réseau de fentes parallèles, les éléments 10 formant alors des lignes ou des bandes.

Le filtre 1 pourrait également comporter deux réseaux périodiques et orthogonaux de fentes. Dans ce cas, les éléments réflecteurs 10 seraient des pavés rectangulaires.

Les fentes 100 débouchent sur la couche 11. En d'autres termes, le fond des fentes 100 est constitué par une partie de la face 110 de la couche 11.

La période P, la largeur l et la hauteur h des fentes sont choisies de façon à ce que les éléments réflecteurs 10 forment une structure sélective en transmission, pour une longueur d'onde comprise dans une gamme déterminée de longueurs d'onde.

Pour le choix de ces paramètres, on peut notamment se référer à l'article de J. Le Perchec et al., Optics Express, Vol. 19, Issue 17, pp. 15720-15731 (2011).

Ainsi, la largeur l des fentes sera choisie inférieure à P/3. De façon générale, plus la largeur l est faible et plus le filtre est sélectif en longueur d'onde.

Par ailleurs, la valeur de la période P est déterminée de façon à régler la longueur d'onde de résonnance sur la longueur d'onde d'intérêt choisie.

Les éléments réflecteurs 10 peuvent notamment être réalisés en métal, par exemple en aluminium, en argent, en or ou en cuivre.

Ils pourront également être réalisés en un matériau pouvant supporter des ondes de surface, comme un matériau absorbant. Ainsi, ce matériau peut être du silicium dans l'ultraviolet et du silicium fortement dopé n ou p dans l'infrarouge.

La hauteur h des éléments réflecteurs 10 ou des fentes 100 est, de préférence, la même pour tous les éléments 10.

Elle est notamment comprise entre l'épaisseur de peau du métal et environ $\lambda/10n$, où n est l'indice de réfraction du matériau inclus dans les fentes, ici de l'air. A titre d'exemple, la hauteur d'un élément réflecteur en aluminium sera comprise entre environ 15 et 500 nm pour de l'aluminium, selon que la longueur d'onde se situe dans le visible ou l'infrarouge. Elle sera par exemple de 25 nm pour un élément réflecteur en or et pour une longueur d'onde de 4 μm.

La couche 11 est réalisée en un matériau présentant un fort indice optique $n_h$. Cet indice est, de préférence, supérieur ou égal à $5/3.n_{max}$, où $n_{max}$ est l'indice optique le plus élevé des matériaux environnants.

Dans l'exemple illustré à la figure 1, la couche 11 ne repose sur aucun substrat. Ainsi, le milieu environnant le filtre 1 est l'air.

Cet exemple de réalisation est notamment illustré par les articles : « Guided mode resonance in subwavelength metallodielectric free-standing grating for bandpass filtering », E. Sakat, G. Vincent, P. Ghenuche, N. Bardou, S. Collin, F. Pardo, J.-L. Pelouard, R. Haïdar, Opt. Lett. 36, 3054 (2011) et « Free-standing subwavelength metallic gratings for snapshot multispectral imaging », R. Haïdar, G. Vincent, S. Collin, N. Bardou, N. Guérineau, J. Deschamps, J.-L. Pelouard, Appl. Phys. Lett. 96, 221104 (2010).

La hauteur $h_h$ de la couche 11 sera de préférence comprise entre environ $0,85.\dfrac{\lambda}{2.n_h}$ et environ $1,5.\dfrac{\lambda}{2.n_h}$, où $\lambda$ est une longueur d'onde de la gamme prédéterminée de longueurs d'onde.

Dans un autre mode de réalisation, le milieu environnant inférieur peut consister en un substrat. Il peut être réalisé en un matériau dont l'indice de réfraction est inférieur à l'indice de réfraction du matériau de la couche 11. S'il est réalisé en un matériau présentant un indice proche de $n_h$, voire supérieur, une couche quart d'onde réalisée en un matériau d'indice de réfraction inférieur à $n_h$ sera intercalée entre le filtre 1 et le substrat.

Dans cette couche 11, sont prévues des inclusions 111 réalisées en un matériau dont l'indice optique $n_b$ est strictement inférieur à l'indice $n_h$ de la couche 11.

L'écart entre les indices $n_h$ et $n_b$ est, de préférence, supérieur ou égal à $0.25\,n_h$.

De façon générale, on constate que la réjection du filtre est améliorée sur une large gamme spectrale lorsque l'écart entre les indices $n_h$ et $n_b$ augmente.

Ainsi, la couche 11 est structurée en remplaçant, dans des zones 111 de la couche 11, le matériau à fort indice de réfraction $n_h$ par un matériau à bas indice de réfraction $n_b$.

Ainsi structurée, la couche 11 conserve une fonction de guide d'onde, fonction qui est ajustée par les inclusions 111 de manière à améliorer les performances de filtrage.

Ces inclusions 111 débouchent sur la surface 112 de la couche 11, opposée à la face 110 qui supporte les éléments réflecteurs 10. Ainsi, dans ce mode de réalisation, les inclusions 111 affleurent sur cette surface 112.

Les essais effectués montrent qu'en ce qui concerne la réjection, ce mode de réalisation est le plus favorable. On pourrait cependant envisager la présence d'une couche de matériau sur la surface 112, notamment si son épaisseur est inférieure à $0,05h_h$.

C'est pourquoi, dans le cadre de la présente demande de brevet, le terme « *affleurant* » pourra désigner des inclusions débouchant sur la surface 112 ou séparées de cette surface extérieure de la couche 11 par une fine couche de matériau.

Dans l'exemple illustré sur la figure 1, ces inclusions 111 sont réparties dans la couche 11, selon une période p égale à P.

D'autres modes de réalisation pourraient être envisagés.

Ces inclusions 111 se présentent ici sous la forme de bandes continues.

Les matériaux constitutifs de la couche 11 et des inclusions 111 sont des matériaux diélectriques au sens optique du terme, c'est-à-dire qu'ils ne sont pas absorbants ou sont peu absorbants à la longueur d'onde d'intérêt.

La hauteur $h_b$ des inclusions 111 sera comprise entre $0,5h_h$ et $0,95\,h_h$. La couche 11 sera formée d'une alternance périodique entre des bandes de matériau d'indice de réfraction $n_h$ et des bandes de matériau d'indice de réfraction $n_b$.

Par ailleurs, la largeur $l_b$ des inclusions 111 sera comprise entre $0,05\,P$ et $0,75\,P$.

La combinaison de ces deux plages de valeurs de $h_b$ et $l_b$ permet d'améliorer la réjection en dehors de la gamme de transmission tout en ayant une bonne transmission dans la gamme voulue.

De préférence, la hauteur $h_b$ et la largeur $l_b$ des inclusions 111 sont choisies de façon suivante.

La hauteur $h_b$ des inclusions 111 sera comprise entre $0,7\,h_h$ et $0,95\,h_h$ et notamment entre $0,8\,h_h$ et $0,9\,h_h$, et sera par exemple égale à environ $0,85\,h_h$.

La largeur $l_b$ des inclusions sera de préférence comprise entre $0,1\,P$ et $0,7\,P$, notamment entre $0,15\,P$ et $0,55\,P$. Des valeurs typiques retenues peuvent être de l'ordre de $0,3\,P$ ou $0,5\,P$.

Ainsi, la réjection est encore améliorée en dehors de la gamme de transmission sans que la transmission soit dégradée dans la gamme de transmission, lorsque les gammes de valeurs de $h_b$ et $l_b$ sont réduites autour des valeurs optimales mentionnées plus haut.

Il convient encore de noter qu'une inclusion n'est pas positionnée de manière quelconque par rapport aux éléments réflecteurs 10. En effet, chaque inclusion 111 est positionnée de façon à être située, au moins en partie, entre deux éléments réflecteurs. Ce positionnement est bien sûr ici considéré dans l'épaisseur du filtre, c'est-à-dire que les inclusions 111 sont bien situées sous les éléments réflecteurs 10, mais au moins en partie en regard d'une fente 100.

De façon générale, le positionnement de référence entre les fentes et les inclusions est un centrage des unes par rapport aux autres.

Cependant, il existe une tolérance dans ce positionnement relatif.

Ainsi, le filtre selon l'invention n'est pas limité au mode de réalisation illustré à la figure 1 et les inclusions 111 pourraient être décalées de façon à n'être chacune qu'en partie en regard d'une fente 100.

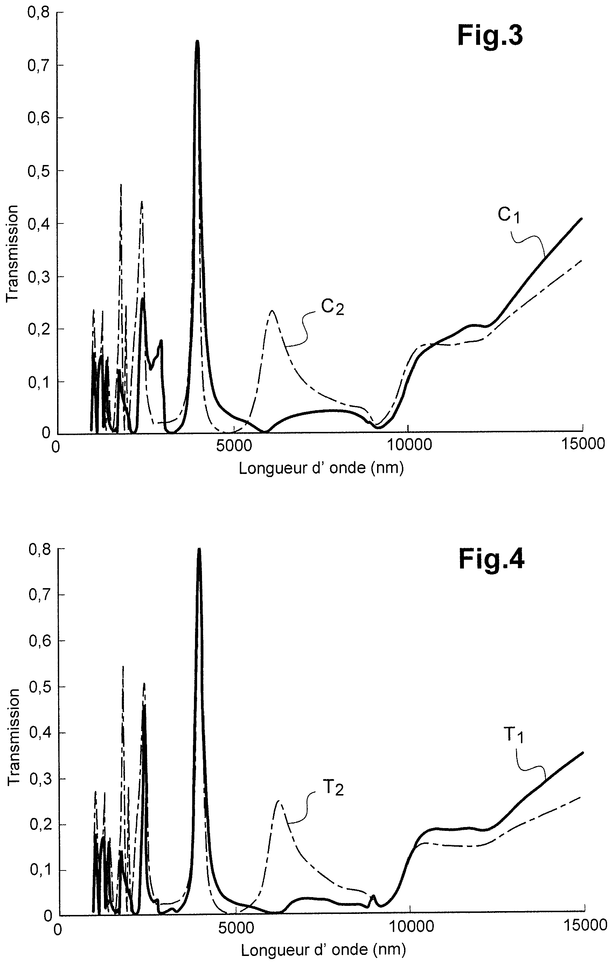

En effet, des essais ont montré que les inclusions illustrées à la figure 1 pouvaient être décalées d'environ 10% de la période P sans que la réjection du filtre soit fortement perturbée. Il s'agit ici du décalage entre le centre de l'inclusion et le centre de la fente. Ces essais ont notamment été réalisés pour le filtre selon l'invention, décrit ci-dessous, en référence à la figure 3.

Cette valeur est assez importante et rend la fabrication robuste par rapport aux erreurs d'alignement couramment rencontrées en microfabrication (typiquement une lithographie UV a une erreur d'alignement de quelques dizaines de nm).

A titre d'exemple, les matériaux suivants pourront être utilisés.

Lorsque le filtre optique selon l'invention est destiné à une longueur d'onde située dans le visible, le matériau à haut indice $n_h$ pourra par exemple être réalisé en $Si_3N_4$, SiC, CdS ou encore ZnS. Le matériau à bas indice $n_b$ des inclusions 111 pourra alors être du $SiO_2$, $CaF_2$ ou encore SiON.

Ainsi, dans le visible, la valeur minimale de l'indice $n_h$ des matériaux à fort indice sera environ 2 (comme $Si_3N_4$) et la valeur maximale de l'indice $n_b$ des matériaux à bas indice sera de l'ordre de 1,5 (comme $SiO_2$). Ceci correspond bien à un écart entre $n_h$ et $n_b$ supérieur ou égal à 0,25 $n_h$.

Lorsque le filtre selon l'invention est destiné à des longueurs d'onde situées dans l'infrarouge, le matériau à fort indice $n_h$ pourra être choisi parmi des matériaux semi-conducteurs dont la longueur d'onde de coupure optique est inférieure à la longueur d'onde d'intérêt. Par exemple, ce matériau pourra être du silicium pour des longueurs d'onde supérieures à 1,1 $\mu$m ou le germanium pour des longueurs d'onde supérieures à 1,5 $\mu$m. D'autres matériaux semi-conducteurs du type II-V ou II-VI à fort indice pourront également convenir. Il convient de noter à cet égard que les matériaux semi-conducteurs présentant un gap faible présentent des indices optiques assez élevés, de l'ordre de 3 à 4.

De plus, les matériaux à fort indice cités précédemment pour un filtre destiné à une longueur d'onde située dans le visible conviennent également pour un filtre destiné à une longueur d'onde située dans l'infra-rouge.

Les matériaux à bas indice de réfraction $n_b$ pourront être par exemple $SiO_2$, MgO, $Al_2O_3$, $ZrO_2$, $TiO_2$ ou encore ZnO, ou bien encore des nitrures ou des sulfures.

De façon préférée, pour des longueurs d'onde d'intérêt inférieures à 8 $\mu$m, on pourra avantageusement choisir une couche 11 en silicium et des inclusions en $SiO_2$. Cette combinaison de matériaux permet de réaliser des filtres à bas coûts, grâce à une fabrication intégrée sur une plateforme technologique utilisant des équipements de dépôt, lithographie, gravure, nettoyage, recuit de dispositifs présentant des motifs de taille micronique et/ou submicronique.

Cependant, pour des longueurs d'onde d'intérêt situées dans la gamme 8-12 $\mu$m, on choisira avantageusement le germanium pour le matériau de la couche 11 et ZnS pour les inclusions. En effet, l'oxyde de silicium est un matériau très absorbant pour une longueur d'onde d'environ 8 $\mu$m, ce qui conduit à préférer un autre matériau pour des longueurs d'onde supérieures à 8 $\mu$m, en particulier dans la bande 8-12 $\mu$m (dite bande III, ou Infrarouge lointain). De façon générale, la situation est similaire pour tous les oxydes et les nitrures. Par contre, les sulfures permettent de contourner cette difficulté, même s'ils présentent un indice de réfraction plus élevé. Il convient de noter que les sulfures peuvent jouer le rôle d'un matériau à fort indice dans le visible mais celui d'un matériau à faible indice dans l'infra-rouge.

De façon générale, l'écart entre les indices $n_b$ et $n_h$ sera plus faible dans le visible que dans l'infrarouge.

Ceci provient de la difficulté à trouver un matériau à fort indice (notamment supérieur à 3) et transparent dans la gamme visible, combiné au fait que les matériaux à faible indice ne changent pas par rapport à la gamme IR (typiquement $SiO_2$ d'indice 1.5).

La réjection sera donc plus faible dans le visible.

Un procédé de réalisation d'un deuxième exemple de réalisation du filtre optique selon l'invention va maintenant être décrit en référence aux figures 2a à 2f.

La figure 2a illustre une première étape de ce procédé, dans laquelle une couche d'oxyde de silicium 3 est déposée sur un substrat en silicium 2.

Ce dépôt peut notamment être réalisé par une technique de dépôt chimique en phase vapeur assisté par plasma (PECVD dans la terminologie anglaise), ou par oxydation thermique à haute température (de l'ordre de 1000°C).

La figure 2b illustre une deuxième étape du procédé dans laquelle une couche 4 de silicium est déposée sur la couche 3, par exemple par PECVD.

La figure 2c illustre une étape de lithographie suivie d'une étape de gravure pour graver localement la couche 4, cette gravure étant arrêtée par la couche 3.

Cette étape de gravure, par exemple une gravure plasma réactive, permet de ménager des zones 40 dépourvues de tout matériau entre des zones 41 en silicium.

Ces zones 40 sont réparties de manière périodique, selon une période p.

La technique de lithographie utilisée est, de préférence, une technique de lithographie optique dans l'UV profond dite DUV dans la terminologie anglaise.

La figure 2d illustre une étape du procédé dans laquelle est déposée, sur la couche 3, une couche de $SiO_2$, de manière à encapsuler le matériau restant de la couche 4.

L'épaisseur de la couche de $SiO_2$ déposée est

supérieure à la hauteur des zones 40 ou 41. Dans un deuxième temps, une étape de polissage mécano-chimique est réalisée pour que la couche obtenue présente la même hauteur que les zones 41.

Ainsi, la couche obtenue sur la couche 3 comporte en alternance des zones 42 formées de $SiO_2$ et des zones 41 formées de silicium.

La figure 2e illustre deux autres étapes du procédé selon l'invention.

La première consiste à déposer une couche complémentaire de silicium sur les zones 40 et 41.

Cette étape permet d'obtenir une couche 11 en silicium, dans laquelle sont présentes des inclusions 111 en $SiO_2$.

Cette couche complémentaire de silicium peut notamment être déposée par une technique du type PECVD.

La deuxième étape consiste à déposer, sur la couche 11, une couche métallique 5, notamment en aluminium.

Dans certains cas, une autre couche, non illustrée sur la figure 2e, peut être déposée entre la couche 11 et la couche 5. Cette couche aura une fonction de barrière de diffusion. Elle pourra s'avérer utile si un traitement thermique est prévu après le dépôt de la couche métallique 5, conduisant à une interdiffusion à l'interface entre les couches 5 et 11.

Cette couche barrière pourra notamment être réalisée en nitrure de silicium.

La figure 2f illustre une dernière étape du procédé selon l'invention qui consiste en une étape de lithographie puis de gravure de la couche 5, par exemple une gravure plasma réactive.

Cette étape de gravure conduit à l'obtention des éléments réflecteurs 10 sur la face 110 de la couche 11.

Ainsi, le filtre 20 obtenu diffère du filtre 1 illustré à la figure 1 en ce qu'il comporte un substrat 2 en silicium, une couche 3 en oxyde de silicium étant prévue entre la couche 11 et le substrat 2.

Il va maintenant être fait référence aux figures 3 à 5 qui permettent de comparer les performances d'un filtre du type illustré dans le document FR-2 959 021 à un filtre selon l'invention, du type du filtre optique 2 illustré à la figure 2f.

Ainsi, la figure 3 comporte deux courbes $C_1$ et $C_2$, la courbe $C_1$ représentant la réponse en transmission d'un filtre optique selon l'invention, en fonction de la longueur d'onde, tandis que la courbe $C_2$ est une courbe similaire pour un filtre optique selon le document FR-2 959 021.

Ces deux filtres comportent tous les deux des éléments réflecteurs définissant un réseau périodique de fentes parallèles, de période P, de hauteur h et de largeur l. Ces éléments réflecteurs sont réalisés en aluminium et forment des bandes parallèles.

La hauteur h des fentes est de 50 nm. La période P du filtre selon l'invention est de 2 000 nm, tandis que la période du filtre selon l'état de la technique est de 1 700 nm. Dans les deux cas, la largeur l des fentes est choisie égale à 0,2 P. Ceci conduit à une valeur de l égale à 400 nm pour le filtre selon l'invention et à 340 nm pour le filtre selon l'état de la technique.

Les éléments réflecteurs sont formés sur une couche de support de hauteur égale à 575 nm.

Pour les deux filtres, cette couche de support est disposée sur une couche de $SiO_2$ présentant une hauteur de 700 nm, cette couche de $SiO_2$ étant elle-même disposée sur un substrat en silicium.

Pour le filtre selon l'état de la technique, la couche de support est seulement constituée en silicium.

Pour le filtre selon l'invention, cette couche de support est en silicium et comporte également des inclusions en $SiO_2$. Ces inclusions sont réparties dans la couche 11, selon une période p égale à 2000 nm, chacune des inclusions étant situées en vis-à-vis d'une fente entre deux éléments réflecteurs.

La hauteur $h_b$ de ces inclusions est choisie égale à $0,8.h_h$ où $h_h$ est la hauteur de la couche de support, ce qui correspond à une valeur de 460 nm. La largeur $l_b$ de ces inclusions est choisie égale 0,2P, ce qui correspond à une valeur de 400 nm.

Comme le montre la figure 3, pour ces deux filtres, la longueur d'onde de résonance est de 4 $\mu$m.

Par ailleurs, il ressort de la figure 3 que, pour la courbe $C_2$, la largeur de la bande spectrale de filtrage est de 0,75 $\lambda$ pour un taux de réjection de 10 dB et de 0,9 $\lambda$ pour un taux de réjection de 5 dB.

Pour la courbe $C_1$, la largeur de la bande spectrale de filtrage est de 1,70 $\lambda$ pour un taux de réjection de 10 dB, tandis qu'elle est égale à environ 2 $\lambda$ pour un taux de réjection de 5 dB.

Ainsi, la figure 3 montre que le filtre selon l'invention permet d'améliorer sensiblement la largeur spectrale de réjection puisqu'elle est doublée, en particulier dans la gamme des grandes longueurs d'onde, c'est-à-dire les longueurs d'onde supérieures à la longueur d'onde de résonnance du filtre.

La figure 4 comporte deux courbes $T_1$ et $T_2$, la courbe $T_1$ représentant la réponse en transmission d'un filtre optique selon l'invention, en fonction de la longueur d'onde, tandis que la courbe $T_2$ est une courbe similaire pour un filtre optique selon le document FR-2 959 021.

Ces deux filtres présentent la même structure que ceux décrits en référence à la figure 3, sauf en ce qui concerne quelques caractéristiques qui vont être détaillées.

Ainsi, le filtre selon le document FR-2 959 021 est identique à celui correspondant à la courbe $C_2$. Les courbes $C_2$ et $T_2$ sont identiques.

Par ailleurs, la période P du filtre optique selon l'invention présente des éléments réflecteurs en aluminium sous forme de bande, répartis selon une période P égale à 1 850 nm. La largeur l des fentes est toujours égale à 0,2 P, ce qui correspond ici à une valeur de 370 nm.

De plus, la hauteur $h_h$ de la couche supportant les éléments réflecteurs et réalisée en silicium est ici égale à 725 nm.

Les inclusions en SiO$_2$ sont conformes à la configuration de la figure 1. Leur hauteur h$_b$ est égale à 0,8 h$_h$, ce qui correspond à une valeur de 580 nm. La largeur l$_b$ de ces inclusions est ici égale à 0,3 P, ce qui correspond à une valeur de 555 nm.

On constate que la hauteur de la couche de support, égale à 575 nm pour le filtre selon l'état de l'art, correspond sensiblement à une valeur de $0,99 \dfrac{\lambda}{2.n_h}$.

Pour le filtre selon l'invention, la hauteur h$_h$ de 725 nm correspond à une valeur de $1,24 \dfrac{\lambda}{2.n_h}$.

En comparant les courbes T$_1$ et T$_2$, on constate que le filtre selon l'invention présente toujours une bonne réjection sur une bande spectrale plus importante que le filtre selon l'état de la technique.

Ainsi, la courbe T$_1$ montre que le filtre selon l'invention présente une réjection d'au moins 13.7 dB sur une bande spectrale de filtrage d'environ 0.74 λ, tandis que la bande correspondante pour la courbe T$_2$ est d'environ 1.73 λ.

Par ailleurs, si l'on compare les courbes C$_1$ et T$_1$, on constate que l'augmentation de la hauteur h$_h$ de la couche de support permet également d'augmenter la largeur de la bande spectrale sur laquelle une réjection donnée est obtenue.

La comparaison entre chacun des deux filtres selon l'invention correspondant aux courbes C$_1$ et T$_1$, et le filtre selon l'état de l'art correspondant aux courbes C$_2$ et T$_2$, ressort du tableau ci-dessous qui donne la largeur de la bande spectrale pour une réjection de 5 dB, 10dB et 13,7 dB.

| | C1 | T1 | état de l'art |
|---|---|---|---|
| 5dB | 2.71λ | 2.73λ | 0.93λ |
| 10dB | 1.72λ | 1.82λ | 0.8λ |
| 13.7dB | 1.07λ | 1.73λ | 0.73λ |

Par ailleurs, la comparaison des courbes C$_1$ et T$_1$ montre que l'augmentation de la largeur de la bande spectrale de filtrage pour une réjection donnée, grâce à l'augmentation de la hauteur de la couche de support, est obtenue tout en conservant les propriétés du pic principal de transmission à la longueur d'onde de résonance, c'est-à-dire 4 μm. En particulier, la valeur maximale de transmission et la largeur à mi-hauteur des courbes C$_1$ et T$_1$ sont sensiblement inchangées.

Par contre, la comparaison des courbes C$_1$ et T$_1$ montre que la valeur maximale de transmission pour le pic secondaire situé à environ 2 425 nm est plus importante pour la courbe T$_1$ que pour la courbe C$_1$. En effet, cette valeur maximale est de l'ordre de 0,53 pour

la courbe T$_1$ et de 0,27 pour la courbe C$_1$.

Le choix entre les deux types de filtre pourra être réalisé en fonction de l'application particulière envisagée.

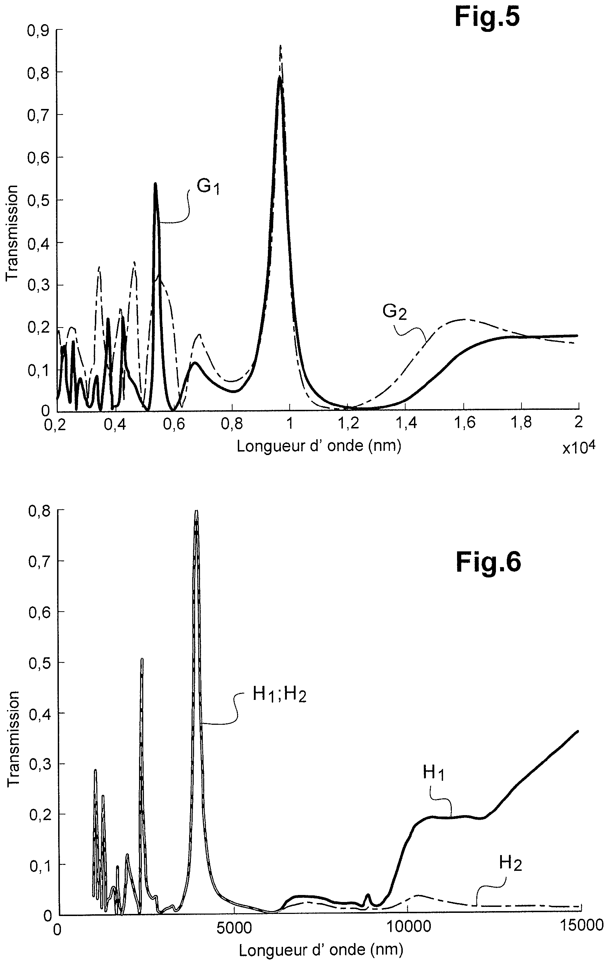

La figure 5 comporte deux courbes G$_1$ et G$_2$, la courbe G$_1$ représentant la réponse en transmission d'un filtre optique selon l'invention, en fonction de la longueur d'onde, tandis que la courbe G$_2$ est une courbe similaire pour un filtre optique selon le document FR-2 959 021.

Ces deux filtres optiques comportent des éléments réflecteurs en aluminium, séparés par un réseau de fentes de période P, de hauteur h et de largeur l.

Pour les deux filtres, la période P est choisie de façon à ce que la valeur de la longueur d'onde de résonnance soit égale à 10 μm.

Pour le filtre selon l'invention, P est égale à 3 350 nm tandis que, pour le filtre selon le document FR-2 959 021, la valeur de P est de 3 570 nm. Dans les deux cas, la hauteur h des fentes est de 50 nm et leur largeur est de 0,2 P. Ceci conduit à une valeur de l égale à 670 nm pour le filtre selon l'invention et à 714 nm pour le filtre selon l'état de la technique.

Dans les deux cas, la couche supportant les éléments réflecteurs est placée sur une couche en ZnS présentant une hauteur de 1 125 nm, cette couche de ZnS étant elle-même supportée par un substrat en silicium.

Pour le filtre selon l'état de la technique, la couche de support est réalisée en germanium et présente une hauteur de 1 250 nm.

Pour le filtre optique selon l'invention, la couche de support présente une hauteur h$_h$ de 1 500 nm. Elle est réalisée en germanium, avec des inclusions de ZnS. La configuration de ces inclusions est conforme à celle illustrée sur la figure 1.

La hauteur h$_b$ de ces inclusions est égale à 0,85 h$_h$, ce qui correspond à une valeur de 1 275 nm.

Par ailleurs, la largeur l$_b$ de ces inclusions est égale à 0,3 P, ce qui correspond à une valeur de 1 005 nm.

La figure 5 montre que, pour une même réjection, par exemple de l'ordre de 8 dB, la bande spectrale correspondante présente une largeur plus importante pour la courbe G$_1$ que pour la courbe G$_2$ (valeur de 1,06 λ comparée à 0,76 λ).

Par ailleurs, des essais ont été réalisés pour déterminer l'influence de l'angle d'incidence de la lumière sur le filtre.

Ces essais ont été réalisés pour les filtres correspondant aux courbes T$_1$ et T$_2$.

Ils ont mis en évidence que les deux filtres présentent la même insensibilité angulaire. Ainsi, pour des angles d'incidence allant jusqu'à 10°, le pic correspondant à la valeur de transmission maximale est toujours obtenu pour une valeur de la longueur d'onde de 4 μm.

Par ailleurs, ces essais montrent que l'élargissement de la bande spectrale, obtenu avec le filtre selon l'invention pour une réjection donnée est insensible à l'angle d'incidence de la lumière, jusqu'à une valeur de 10°.

Les courbes $C_1$, $T_1$ et $G_1$ illustrées aux figures 3 à 5 montrent que, pour des longueurs d'onde supérieures à 10 $\mu$m pour les courbes $C_1$ et $T_1$ et à 14 $\mu$m pour la courbe $G_1$, les valeurs de transmission augmentent de manière significative.

Pour limiter ce phénomène, on peut envisager de doper le matériau semi-conducteur utilisé pour fabriquer le filtre, et plus particulièrement la couche supérieure du substrat.

Ainsi, la figure 6 comporte deux courbes $H_1$ et $H_2$. La courbe $H_1$ représente la réponse en transmission du filtre optique selon l'invention correspondant à la courbe $T_1$. Ainsi, les courbes $H_1$ et $T_1$ sont identiques. La courbe $H_2$ correspond au même filtre, dans lequel une lame réalisée en silicium dopé n a été insérée entre le substrat en silicium et la couche de SiO$_2$. Cette lame correspond, en pratique, à la partie supérieure du substrat qui a été dopée.

Cette lame présente une hauteur de 2 $\mu$m.

La comparaison des courbes $H_1$ et $H_2$ montre que cette lame permet de limiter fortement la transmission pour des longueurs d'onde supérieures à 9 $\mu$m.

On constate par ailleurs que l'insertion de cette lame en silicium dopé conduit à une diminution de la valeur du pic principal de transmission à la longueur d'onde de 4 $\mu$m. Cependant, cette diminution n'est que de 20%. Elle est donc acceptable pour le bon fonctionnement du filtre, compte tenu de la limitation de la transmission pour les grandes longueurs d'onde.

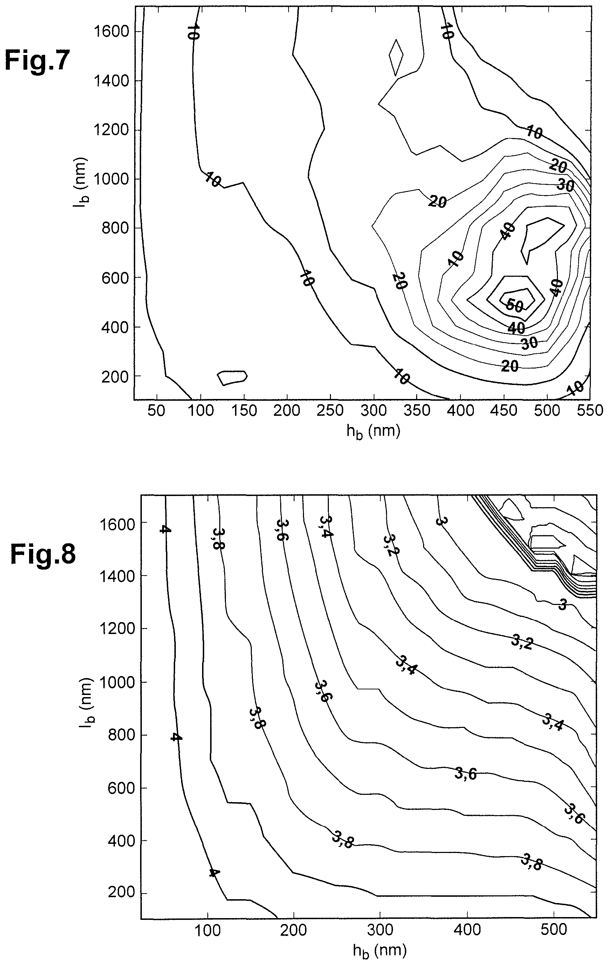

Il est maintenant fait référence à la figure 7 qui illustre, pour un filtre optique selon l'invention, la valeur maximale d'une fonction de coût F , en fonction de la hauteur $h_b$ des inclusions (en abscisses) et de leur largeur $l_b$ (en ordonnées).

La fonction de coût est définie comme :

$$F(h_b, l_b) = \frac{T_{35}^2(h_b, l_b)}{T_{23}(h_b, l_b) T_{57}(h_b, l_b)}$$

où $T_{35}$ ($h_b$, $l_b$) (respectivement $T_{23}$ ($h_b$, $l_b$), $T_{57}$ ($h_b$, $l_b$)) correspond à la transmission maximale dans la bande spectrale [3-5]$\mu$m (respectivement [2-3]$\mu$m, [5-7]$\mu$m) d'un filtre ayant les caractéristiques ci-dessous. Etant donné sa définition, cette fonction de coût F sera maximisée pour une dimension donnée de l'inclusion, lorsque l'on aura une forte rejection hors du pic de transmission principal apparaissant dans la bande spectrale [3-5]$\mu$m. Ainsi, cette fonction de coût atteint une valeur supérieure à 50 pour $h_b$=475 nm et $l_b$=500 nm.

La figure 7 est obtenue pour un filtre selon l'invention comportant des éléments réflecteurs en or, séparés par un réseau de lignes parallèles. La période P de ce réseau est 1 760 nm, la largeur l des fentes est de 360 nm et la hauteur des fentes est de 50 nm.

Le filtre optique comporte une couche de support dont la hauteur $h_h$ est égale à 575 nm. Cette couche de support est réalisée en silicium et présente des inclusions en SiO$_2$ de largeur $l_b$ et de hauteur $h_b$.

Cette couche de support est déposée sur une couche de SiO$_2$ présentant une hauteur de 700 nm, elle-même déposée sur un substrat en silicium.

L'introduction des inclusions fait varier la longueur d'onde de résonnance du filtre, laquelle dépend des valeurs de $h_b$ et $l_b$. Ainsi, la figure 8 illustre la valeur de la longueur d'onde de résonnance en fonction de $h_b$ et $l_b$.

La figure 7 montre qu'une bonne réjection est obtenue pour une valeur de $h_b$ comprise entre 0,5$h_h$ et $h_h$ ou encore entre 0,5 $h_h$ et 0,95 $h_h$, et pour des valeurs de $l_b$ comprises entre 0,05 P et 0,75 P.

La réjection est optimisée pour une valeur de $l_b$ égale à 0,28 P et une valeur de $h_b$ égale à 0,8 $h_h$. Ces valeurs sont cohérentes avec celles indiquées précédemment, compte tenu du fait qu'elles sont obtenues par simulation.

Ainsi, un filtre optique selon l'invention présente de nombreux avantages par rapport aux filtres optiques selon l'état de l'art.

Tout d'abord, il présente une très bonne réjection sur une gamme spectrale très étendue.

Un filtre optique selon l'invention peut comporter une couche de support réalisée en une combinaison de Si et de SiO$_2$, notamment lorsque le filtre est destiné à des longueurs d'onde situées entre 1 et 8 $\mu$m. Le filtre optique peut alors être facilement être réalisé par une technologie CMOS, ce qui permet de réduire son coût de fabrication.

Les filtres optiques selon l'invention assurent également une bonne transmission, typiquement supérieure à 70%, sur une gamme spectrale étroite.

Ils présentent une bonne insensibilité angulaire en ce qui concerne la position de la longueur d'onde de résonnance et la transmission de ces filtres et ce, jusqu'à un angle d'environ 10°.

Enfin, les filtres selon l'invention sont sélectifs en transmission (passe-bande) et en réflexion (coupe-bande) et sont compacts.

Les signes de référence insérés après les caractéristiques techniques figurant dans les revendications ont pour seul but de faciliter la compréhension de ces dernières et ne sauraient en limiter la portée.

**Revendications**

1. Filtre optique en fréquences comprenant une couche de support (11) sur laquelle sont formés des éléments réflecteurs (10) définissant au moins un réseau périodique de fentes sensiblement parallèles, la période P, la hauteur h et la largeur l des fentes étant choisies de façon à ce que les éléments réflecteurs forment une structure sélective en longueur d'onde pour une longueur d'onde comprise dans une gamme déterminée de longueurs d'onde,
dans lequel la couche de support (11) est formée d'un matériau d'indice de réfraction $n_h$ et comporte des inclusions (111) en un matériau d'indice de réfraction $n_b$, $n_b$ étant strictement inférieur à $n_h$, ces inclusions affleurant sur la surface (112) de la couche de support opposée à celle (110) sur laquelle les éléments réflecteurs sont formés et présentant une hauteur $h_b$, telle que $0,5.h_h \leq h_b < 0,95.h_h$ où $h_h$ est la hauteur de la couche de support, et une largeur $l_b$, telle que $0,05P \leq l_b \leq 0,75P$, et chaque inclusion étant située au moins en partie entre deux éléments réflecteurs.

2. Filtre optique selon la revendication 1, **caractérisé en ce que** la différence entre les deux indices de réfraction $n_h$ et $n_b$ est supérieure ou égale à $0,25\, n_h$.

3. Filtre optique selon la revendication 1 ou 2, **caractérisé en ce que** la hauteur $h_h$ de la couche de support (11) sera telle que

$$0,85.\frac{\lambda}{2.n_h} \leq h_h \leq 1,5.\frac{\lambda}{2.n_h},$$

où $\lambda$ est une longueur d'onde de la gamme prédéterminée de longueurs d'onde.

4. Filtre optique selon l'une des revendications 1 à 3, **caractérisé en ce que** l'indice de réfraction $n_h$ est supérieur ou égal à $5/3.n_{max}$, où $n_{max}$ est l'indice de réfraction le plus élevé des matériaux environnants.

5. Filtre optique selon l'une des revendications 1 à 4, **caractérisé en ce qu'**il comprend un substrat (2), une couche (3) réalisée en un matériau d'indice de réfraction inférieur à $n_h$ étant disposée entre la couche de support (11) et le substrat (2).

6. Filtre optique selon l'une des revendications 1 à 5, **caractérisé en ce que** la largeur des fentes dudit au moins un réseau périodique est inférieure au tiers de la période P du réseau.

7. Filtre optique selon l'une des revendications 1 à 6, **caractérisé en ce que** les éléments réflecteurs (10) sont réalisés en métal et ont une hauteur comprise entre l'épaisseur de peau du métal et $\frac{\lambda}{10.n}$, où n est l'indice de réfraction du matériau inclus dans les fentes et $\lambda$ est une longueur d'onde de la gamme prédéterminée de longueurs d'onde.

8. Détecteur pour la détection d'un rayonnement électromagnétique dans une gamme prédéterminée de longueurs d'onde, comprenant un circuit de détection sensible à ladite gamme de longueurs d'onde, **caractérisé en ce qu'**il comporte un filtre optique selon l'une des revendications 1 à 7.

**Patentansprüche**

1. Optisches Frequenzfilter, das eine Tragschicht (11) umfasst, auf der reflektierende Elemente (10) gebildet sind, die mindestens ein periodisches Netzwerk von im Wesentlichen parallelen Schlitzen bilden, wobei die Periode P, die Höhe h und die Breite l der Schlitze derart ausgewählt sind, dass die reflektierenden Elemente eine hinsichtlich der Wellenlänge selektive Struktur für eine Wellenlänge bilden, die in dem bestimmten Wellenlängenbereich enthalten sind, wobei die Tragschicht (11) aus einem Material mit einem Brechungsindex $n_h$ gebildet ist und Einschlüsse (111) aus einem Material mit einem Brechungsindex $n_b$ beinhaltet, der strikt kleiner ist als $n_h$, wobei diese Einschlüsse auf der Oberfläche (112) der Tragschicht bündig sind, die jener (110) entgegengesetzt ist, auf der die reflektierenden Elemente gebildet sind, und eine Höhe $h_b$ derart aufweisen, dass $0,5.h_h \leq h_b < 0,95.h_h$ ist, wobei $h_h$ die Höhe der Tragschicht ist, und eine Breite $l_b$ derart, dass $0,05\, P \leq l_b \leq 0,75\, P$ ist, und jeder Einschluss mindestens zum Teil zwischen zwei reflektierenden Elementen liegt.

2. Optisches Filter nach Anspruch 1, **dadurch gekennzeichnet, dass** der Unterschied zwischen den zwei Brechungsindizes $n_h$ und $n_b$ größer oder gleich 0,25 $n_h$ ist.

3. Optisches Filter nach Anspruch 1 oder 2, **dadurch gekennzeichnet, dass** die Höhe $h_h$ der Tragschicht (11) derart ist, dass

$$0,85.\frac{\lambda}{2.n_h} \leq h_h \leq 1,5.\frac{\lambda}{2.n_h},$$

wobei $\lambda$ eine Wellenlänge des vorbestimmten Wellenlängenbereichs ist.

4. Optisches Filter nach einem der Ansprüche 1 bis 3, **dadurch gekennzeichnet, dass** der Brechungsindex $n_h$ größer oder gleich $5/3.n_{max}$ ist, wobei $n_{max}$ der höchste Brechungsindex der umgebenden Materialien ist.

5. Optisches Filter nach einem der Ansprüche 1 bis 4, **dadurch gekennzeichnet, dass** es ein Substrat (2) umfasst, wobei eine Schicht (3), die aus einem Material mit einem Brechungsindex kleiner als $n_h$ hergestellt ist, zwischen der Tragschicht (11) und dem Substrat (2) angeordnet ist.

6. Optisches Filter nach einem der Ansprüche 1 bis 5, **dadurch gekennzeichnet, dass** die Breite der Schlitze des mindestens einen periodischen Netzwerks kleiner ist als das Drittel der Periode P des Netzwerks.

7. Optisches Filter nach einem der Ansprüche 1 bis 6, **dadurch gekennzeichnet, dass** die reflektierenden Elemente (10) aus Metall hergestellt sind und eine Höhe aufweisen, die zwischen der Hautstärke des Metalls und $\dfrac{\lambda}{10.n}$ liegt, wobei n der Brechungsindex des Materials ist, das in den Schlitzen enthalten ist, und $\lambda$ eine Wellenlänge des vorbestimmten Wellenlängenbereichs ist.

8. Detektor zum Detektieren einer elektromagnetischen Strahlung in einem vorbestimmten Wellenlängenbereich, der eine Detektionsschaltung umfasst, die für den Wellenlängenbereich empfindlich ist, **dadurch gekennzeichnet, dass** er ein optisches Filter nach einem der Ansprüche 1 bis 7 beinhaltet.

**Claims**

1. Optical frequency filter comprising a support layer (11) on which reflector elements (10) are formed defining at least one periodic grid of substantially parallel slits, the period P, the height h and the width l of the slits being selected such that the reflector elements form a wavelength-selective structure for a wavelength within a predetermined range of wavelengths,
   wherein the support layer (11) is formed from a material with a refractive index $n_h$, and comprises inclusions (111) made of a material with a refractive index $n_b$, $n_b$ being strictly less than $n_h$, with these inclusions flush on the surface (112) of the support layer opposite the one (110) on which the reflector elements are formed and having a height $h_b$, such that $0.5.h_h \leq h_b < 0.95.h_h$ where $h_h$ is the height of the support layer, and a width $l_b$, such that $0.05P \leq l_b \leq 0.75P$, and each inclusion being located at least partially between two reflector elements.

2. Optical filter according to claim 1, **characterised in that** the difference between the two refractive indexes $n_h$ and $n_b$ is greater than or equal to $0.25\, n_h$.

3. Optical filter according to claim 1 or 2, **characterised in that** the height $h_h$ of the support layer (11) will be such that $0.85.\dfrac{\lambda}{2.nh} \leq h_h \leq 1.5.\dfrac{\lambda}{2.nh}$ where $\lambda$ is a wavelength from the predetermined range of wavelengths.

4. Optical filter according to one of claims 1 to 3, **characterised in that** the refractive index $n_h$ is greater than or equal to $5/3.n_{max}$, where $n_{max}$ is the highest refractive index of the surrounding materials.

5. Optical filter according to one of claims 1 to 4, **characterised in that** it comprises a substrate (2), a layer (3) made from a material with a refractive index less than $n_h$ being arranged between the support layer (11) and the substrate (2).

6. Optical filter according to one of claims 1 to 5, **characterised in that** the width of the slits of said at least one periodic grid is less than one third of the period P of the grid.

7. Optical filter according to one of claims 1 to 6, **characterised in that** the reflector elements (10) are made of metal and have a height of between the thickness of the skin of the metal and $\dfrac{\lambda}{10.n}$, where n is the refractive index of the material included in the slits and $\lambda$ is a wavelength of the predetermined range of wavelengths.

8. Detector for detecting electromagnetic radiation in a predetermined range of wavelengths, comprising a detection circuit that is sensitive to said range of wavelengths, **characterised in that** it comprises an optical filter according to one of claims 1 to 7.

**Fig.1**

**Fig.2a**

**Fig.2b**

**Fig.2c**

**Fig.2d**

**Fig.2e**

**Fig.2f**

Fig.3

Fig.4

**Fig.5**

**Fig.6**

**Fig.7**

**Fig.8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2959021
- US 20090041971 A
- US 20100328587 A
- WO 2012105555 A

**Littérature non-brevet citée dans la description**

- **J.A. PORTO et al.** Transmission résonances on metallic gratings with very narrow slits. *Physical Review Letters,* 1999, vol. 83, 2845
- **G. VINCENT et al.** Large-area dielectric and metallic freestanding gratings for midinfrared optical filtering application. *Journal of Vacuum Science Technology,* 2008, vol. B 26, 852
- **J. LE PERCHEC et al.** *Optics Express,* 2011, vol. 19 (17), 15720-15731
- **E. SAKAT ; G. VINCENT ; P. GHENUCHE ; N. BARDOU ; S. COLLIN ; F. PARDO ; J.-L. PELOUARD ; R. HAÏDAR.** Guided mode resonance in subwavelength metallodielectric free-standing grating for bandpass filtering. *Opt. Lett.,* 2011, vol. 36, 3054
- **R. HAÏDAR ; G. VINCENT ; S. COLLIN ; N. BARDOU ; N. GUÉRINEAU ; J. DESCHAMPS ; J.-L. PELOUARD.** Free-standing subwavelength metallic gratings for snapshot multispectral imaging. *Appl. Phys. Lett.,* 2010, vol. 96, 221104